# EUROPEAN PATENT SPECIFICATION

(11) **EP 4 141 541 B1**
(45) Date of publication and mention of the grant of the patent: **11.03.2026**
(21) Application number: 21791621.2
(22) Date of filing: 20.04.2021
(51) Int. Cl.: G03B 21/20, H04N 9/31, G02F 1/365, F21V 8/00, G03B 21/16, G02B 27/14, H01S 3/02, H01S 3/063, H01S 3/094, H01S 5/02, H01S 5/323, H01S 5/40, H01S 3/16, H01S 3/23, H01S 3/06, H01S 3/0941

(54) **PROJECTION SYSTEM**
PROJEKTIONSSYSTEM
SYSTÈME DE PROJECTION

(30) Priority: 24.04.2020 JP 2020077826
(43) Date of publication of application: 01.03.2023
(73) Proprietor: Panasonic Intellectual Property Management Co., Ltd., Osaka-shi, Osaka 540-6207 (JP)
(72) Inventor: MIZOKAMI, Yosuke, Chuo-ku, Osaka-shi, Osaka 540-6207 (JP); SATO, Toshihiko, Chuo-ku, Osaka-shi, Osaka 540-6207 (JP); NANAI, Norishige, Chuo-ku, Osaka-shi, Osaka 540-6207 (JP)
(74) Representative: Müller-Boré & Partner Patentanwälte PartG mbB
(86) International application number: PCT/JP2021/016012
(87) International publication number: WO 2021/215431

(56) References cited:
- EP-A1- 4 001 749
- WO-A1-2006/049262
- WO-A1-2006/109730
- WO-A1-2011/055812
- WO-A1-2013/111271
- JP-A- 2001 264 662
- JP-A- 2007 165 762
- JP-A- 2010 078 622
- US-A1- 2008 036 921
- US-A1- 2009 067 453
- US-A1- 2010 073 638
- US-A1- 2017 063 019

## Description

### Technical Field

The present disclosure generally relates to projection systems, and more particularly relates to a projection system including a projection optical system.

### Background Art

Conventionally, there has been proposed a projector device, which includes: a light source unit; a spatial light modulation device that controls, in each pixel, light emitted from the light source unit to form an optical image; and a projection optical system that projects the optical image formed by the spatial light modulation device onto a target screen (e.g., refer to Patent Literature 1).

The light source unit includes a solid-state light source and a wavelength-converting device. The solid-state light source emits first light including: blue light having a peak wavelength within a range of 430 nm to 470 nm; and green light having a peak wavelength within a range of 480 nm to 550 nm. The wavelength-converting device include at least red phosphors that includes Ce as a luminescence center. The red phosphors emit second light, when received green light. The spectrum of the second light has a peak wavelength within a range of 600 nm to 700 nm.

There has been a problem that a lighting apparatus described in Patent Literature 1 hardly enhances intensity of wavelength-converting light.
Patent Literature 2 describes a laser light source and optical device, wherein the laser light source is provided with a pump light source comprising a semiconductor laser, a solid laser medium which is excited by the semiconductor laser, and multi-mode means for changing at least either a longitudinal mode or a transverse mode of laser oscillation of the solid laser.
Patent Literature 3 describes a projection display apparatus that is capable of reducing speckle noise, with no image of a flaw or dust noticeable in or on a screen even if it exists in or on an optical component.
Patent Literature 4 describes a video projector using a coherent light source, wherein in the video projector, a fiber part of a fiber laser is disposed so as to draw a circulating orbit of more than one circulation along the inner wall of the projector housing. Further, an FBG which constitutes the fiber laser is fixed so that its shape is not changed. Furthermore, a pump LD part of the fiber laser is disposed apart from the SHG element.
Patent Literature 5 describes a technique for increasing the intensity of light having a different wavelength from excitation light, wherein a light-emitting device includes an optical fiber, a first light source unit, and a second light source unit. The optical fiber includes a light incident portion, a light emerging portion, and a wavelength converting portion.

### Citation List

### Patent Literature

Patent Literature 1: JP 2018-138991 A
Patent Literature 2: US 2009/067453 A1
Patent Literature 3: US 2010/073638 A1
Patent Literature 4: US 2008/036921 A1
Patent Literature 5: EP 4 001 749 A1

### Summary of Invention

The claimed invention is defined by the independent claims, while preferred embodiments form the subject of the dependent claims.
It is therefore an object of the present disclosure to provide a projection system, which can suppress an increase in temperature.

### Brief Description of Drawings

FIG. 1 is a diagram showing a configuration of a projection system according to a first embodiment; not part of the invention,
FIG. 2 is a cross-sectional view of an optical fiber of the projection system;
FIGS. 3A to 3C are explanatory diagrams for explaining an operating principle of a light source unit of the projection system;
FIG. 4 is a diagram showing a configuration of a projection system according to a second embodiment; not part of the invention,
FIG. 5 is a diagram showing a configuration of a projection system according to a third embodiment; not part of the invention,
FIG. 6 is a diagram showing a configuration of a projection system according to a fourth embodiment; not part of the invention,
FIG. 7 is a diagram showing a configuration of a projection system according to a fifth embodiment; not part of the invention and
FIG. 8 is a diagram showing a configuration of a projection system according to a sixth embodiment, which is part of the invention.

### Description of Embodiments

The drawings to be referred to in the following description of first to sixth embodiments and the like are all schematic representations. That is to say, the ratio of the dimensions (including thicknesses) of respective constituent elements illustrated on the drawings does not always reflect their actual dimensional ratio.

### (First Embodiment)

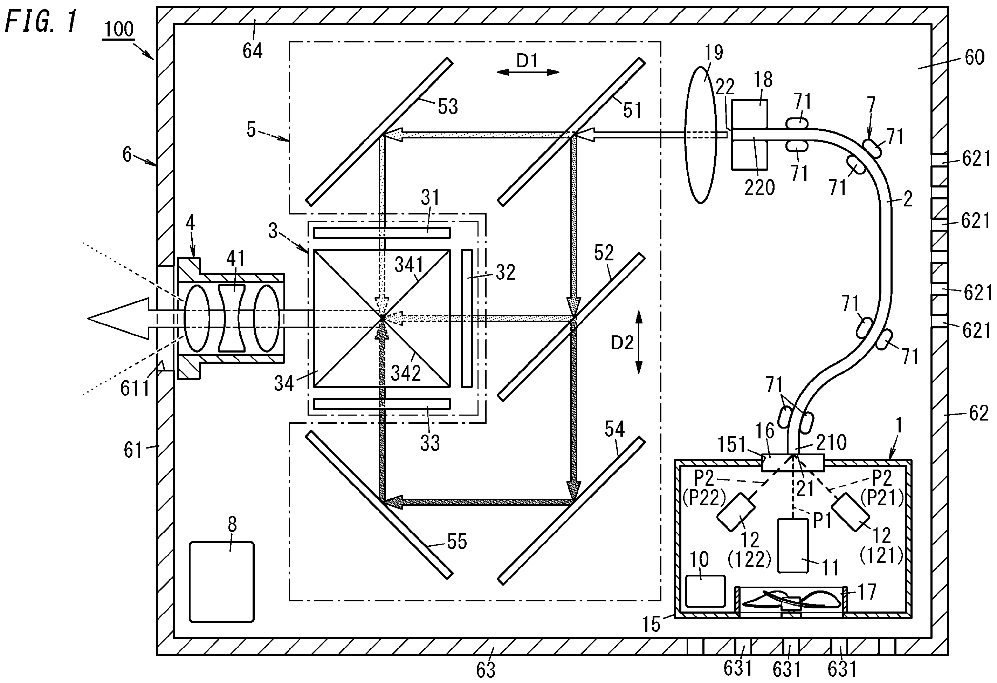

Hereinafter, a projection system 100 according to a first embodiment will be described with reference to FIGS. 1 to 3C.

### (1) Overview

As illustrated in FIG. 1, the projection system 100 includes a light source unit 1, a spatial light modulation unit 3 and a projection optical system 4. In the projection system 100, the spatial light modulation unit 3 modulates white light emitted from the light source unit 1, and the light modulated is projected from the projection optical system 4. The projection system 100 is assumed to be e.g., a projector, but this is only an example and should not be construed as limiting. The projection system 100 may be implemented as e.g., a rear projection system, or a head-up display. The light source unit 1 includes an optical fiber 2, a first light source part 11 and a second light source part 12 and is configured such that white light is emerged from a light emerging portion 22 of the optical fiber 2.

### (2) Configuration of Projection System

As illustrated in FIG. 1, the projection system 100 includes the light source unit 1, the spatial light modulation unit 3 and the projection optical system 4. The projection system 100 further includes a light separation unit 5 configured to separate the light (white light) emitted from the light source unit 1 into red light, green light and blue light.

Hereinafter, the light separation unit 5, the spatial light modulation unit 3 and the projection optical system 4 will be described in that order, and then the light source unit 1 will be described.

### (2.1) Light Separation Unit

The light separation unit 5 includes a first dichroic mirror 51, a second dichroic mirror 52, a first mirror 53, a second mirror 54 and a third mirror 55.

The first dichroic mirror 51 and the first mirror 53 are disposed on an extension line of an optical axis of the optical fiber 2 in that order from the light emerging portion 22 of the optical fiber 2. The first dichroic mirror 51 and the first mirror 53 are disposed in almost parallel to each other. Also, the first dichroic mirror 51 and the first mirror 53 are arranged in first directions D1, and the first dichroic mirror 51, the second dichroic mirror 52 and the second mirror 54 are disposed such that the second dichroic mirror 52 is between the first dichroic mirror 51 and the second mirror 54 in second directions D2 orthogonal to the first directions D1. The first dichroic mirror 51, the second dichroic mirror 52 and the second mirror 54 are disposed in almost parallel to one another. The second mirror 54 and the third mirror 55 are arranged in that order in the first directions D1. The first mirror 53 and the third mirror 55 are arranged in the second directions D2. The second mirror 54 and the third mirror 55 are in non-parallel to each other. The first mirror 53 and the third mirror 55 are in non-parallel to each other.

The first dichroic mirror 51 allows red light in the light (white light) emitted from the light source unit 1 to pass therethrough, but reflects cyan light including green light components and blue light components in the light (white light) toward the second dichroic mirror 52.

The red light passing through the first dichroic mirror 51 is reflected by the first mirror 53 and then enters the spatial light modulation unit 3.

The second dichroic mirror 52 reflects the green light of the cyan light reflected by the first dichroic mirror 51 toward the spatial light modulation unit 3, but allows the blue light of the cyan light to pass therethrough.

The second mirror 54 reflects the blue light, passing through the second dichroic mirror 52, toward the third mirror 55.

The third mirror 55 reflects the blue light, reflected by the second mirror 54, toward the spatial light modulation unit 3.

### (2.2) Spatial Light Modulation Unit

The spatial light modulation unit 3 is configured to control emission light emitted from the light source unit 1 to form an optical image. The spatial light modulation unit 3 is disposed to be surrounded by the light separation unit 5 and the projection optical system 4. The spatial light modulation unit 3 includes a first liquid crystal panel 31, a second liquid crystal panel 32, a third liquid crystal panel 33 and a cross dichroic prism 34. In the spatial light modulation unit 3, the cross dichroic prism 34 is located between the first liquid crystal panel 31 and the third liquid crystal panel 33 in the second directions D2, but between the second liquid crystal panel 32 and the projection optical system 4 in the first directions D1.

The cross dichroic prism 34 is disposed to combine: the red light passing through the first liquid crystal panel 31; the green light passing through the second liquid crystal panel 32; and the blue light passing through the third liquid crystal panel 33 to allow the combined light to enter the projection optical system 4.

The cross dichroic prism 34 includes: a first film (first dielectric multilayer film) 341, which reflects the red light coming from the first liquid crystal panel 31, but allows the green light coming from the second dichroic mirror 52 to pass therethrough; and a second film (second dielectric multilayer film) 342, which reflects the blue light coming from the third mirror 55, but allows the green light coming from the second dichroic mirror 52 to pass therethrough. The first film 341 and the second film 342 are disposed to be orthogonal to each other. The first film 341 is in almost parallel to the first mirror 53 and the second dichroic mirror 52. The second film 342 is in almost parallel to the third mirror 55.

The red light reflected by the first mirror 53 is incident on the first liquid crystal panel 31. The green light reflected by the second dichroic mirror 52 is incident on the second liquid crystal panel 32. The blue light reflected by the third mirror 55 is incident on the third liquid crystal panel 33.

The first liquid crystal panel 31, the second liquid crystal panel 32 and the third liquid crystal panel 33 are implemented as, for example, an active matrix drive type of transmissive liquid crystal display, but this is only an example and should not be construed as limiting. The first liquid crystal panel 31, the second liquid crystal panel 32 and the third liquid crystal panel 33 are controlled by a controller 8. The controller 8 is configured to control the first liquid crystal panel 31, the second liquid crystal panel 32 and the third liquid crystal panel 33 according to image information (image signal) given from an external device, for example. Thus, the spatial light modulation unit 3 modulates the red light, the green light and the blue light, in each pixel of the optical image, and causes the cross dichroic prism 34 to combine those lights, and accordingly can cause the light of the optical image formed by the combination to enter the projection optical system 4. The projection system 100 can project a color image from the projection optical system 4 by the controller 8 appropriately controlling the first liquid crystal panel 31, the second liquid crystal panel 32 and the third liquid crystal panel 33. The color image may be a still image or a moving image.

The controller 8 includes a computer system. The computer system includes a processor and a memory as hardware components. The functions of the controller 8 according to the present disclosure may be realized by making the processor execute a program stored in the memory of the computer system. The program may be stored in advance in the memory of the computer system. Alternatively, the program may also be downloaded through a telecommunications line or be distributed after having been recorded in some non-transitory storage medium such as a memory card, an optical disc, or a hard disk drive, any of which is readable for the computer system. The processor of the computer system may be implemented as a single or a plurality of electronic circuits including a semiconductor integrated circuit (IC) or a large-scale integrated circuit (LSI). As used herein, the "integrated circuit" such as an IC or an LSI is called by a different name depending on the degree of integration thereof. Examples of the integrated circuits include a system LSI, a very large-scale integrated circuit (VLSI), and an ultra-large scale integrated circuit (ULSI). Optionally, a field-programmable gate array (FPGA) to be programmed after an LSI has been fabricated or a reconfigurable logic device allowing the connections or circuit sections inside of an LSI to be reconfigured may also be adopted as the processor. Those electronic circuits may be either integrated together on a single chip or distributed on multiple chips, whichever is appropriate. Those multiple chips may be integrated together in a single device or distributed in multiple devices without limitation. As used herein, the "computer system" includes a microcontroller including one or more processors and one or more memories. Thus, the microcontroller may also be implemented as a single or a plurality of electronic circuits including a semiconductor integrated circuit or a large-scale integrated circuit.

### (2.3) Projection Optical System

The projection optical system 4 is configured to project an image (color image) including the combined light coming from the spatial light modulation unit 3. The image emitted from the projection optical system 4 is projected on, for example, a screen crossing an extension line of an optical axis of the projection optical system 4. The projection optical system 4 includes a projection lens 41 disposed to project the image coming from the cross dichroic prism 34. The projection lens 41 may be a multi-lens.

### (2.4) Light Source Unit

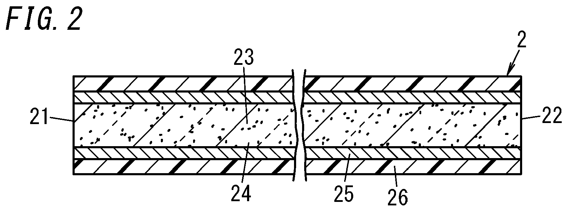

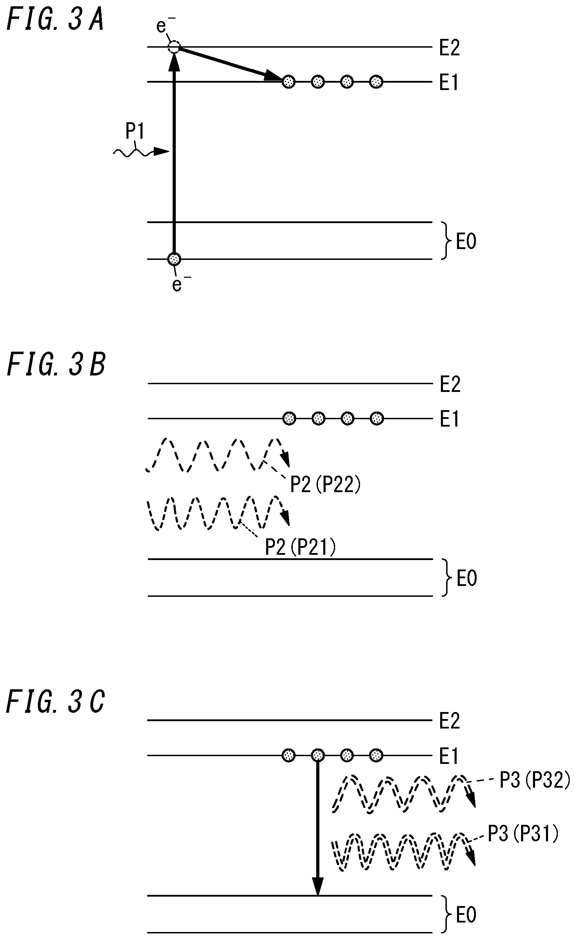

As illustrated in FIG. 1, the light source unit 1 causes excitation light P1 and seed light P2 to enter the optical fiber 2 (refer to FIG. 2) into which wavelength-converting elements (one or more chemical elements) are added. The excitation light P1 is light for exciting the wavelength-converting elements. The seed light P2 is light for producing stimulated emission of light P3 (refer to FIG. 3C) from the wavelength-converting elements excited by the excitation light P1. The optical fiber 2 emits light including the excitation light P1 and the stimulated emission of light P3. FIGS. 3A to 3C are explanatory diagrams for explaining an operating principle of the light source unit 1 of the projection system 100. In FIGS. 3A, 3B and 3C, the ordinate represents the energy of electrons. The upward arrow illustrated in FIG. 3A indicates absorption of the excitation light P1. The downward arrow illustrated in FIG. 3C indicates transition relating to spontaneous emission of light or the stimulated emission of light P3. In the projection system 100, electrons e⁻ on a ground level E0 (including a plurality of energy levels), of the wavelength-converting elements, are excited to an excitation level E2 by the excitation light P1 entering the optical fiber 2. The electrons e⁻ at the excitation level E2 makes a transition to a metastable level E1, which is an energy level lower than the excitation level E2. Thereafter, stimulated emission of light P3 (P32) is produced, when the electrons e⁻ at the metastable level E1 is caused to make a transition to one of the highest ones (hereinafter, referred to also as a "second energy level") of the plurality of energy levels of the ground level E0 by seed light P2 (P22), of which a wavelength corresponds to an energy difference between the metastable level E1 and the second energy level, for example. Also, stimulated emission of light P3 (P31) is produced, when the electrons e⁻ at the metastable level E1 is caused to make a transition to a first energy level lower than the second energy level out of the plurality of energy levels of the ground level E0, by seed light P2 (P21), of which a wavelength corresponds to an energy difference between the metastable level E1 and the first energy level.

As illustrated in FIG. 1, the light source unit 1 includes the optical fiber 2, a first light source part 11 and a plurality of second light source parts 12. The first light source part 11 is configured to make the excitation light P1 incident on the light incident portion 21. The second light source parts 12 are configured to make the seed light P2 (hereinafter, referred to also as external seed light P2) incident on the light incident portion 21. The seed light P2 is light for causing the wavelength-converting elements excited by the excitation light P1 to produce the stimulated emission of light P3.

### (2.4.1) Optical Fiber

As illustrated in FIG. 2, the optical fiber 2 includes a core 24, a clad 25 and a coating portion 26. The clad 25 covers an outer peripheral surface of the core 24. The coating portion 26 is provided to cover an outer peripheral surface of the clad 25. The cross sectional, taken along a plane perpendicular to an optical axis direction, of the core 24, has a circular shape. The clad 25 is disposed coaxially with the core 24.

The core 24 has a first end face and a second end face, which is located at the opposite longitudinal end of the core 24 from the first end face. The core 24 includes a light-transmitting material and the wavelength-converting elements. The concentration of the wavelength-converting elements in the core 24 may or may not be uniform along the entire length of the core 24. The core 24 has almost the same refractive index as that of the light-transmitting material, as a main ingredient of the core 24. The core 24 may be configured such that a part containing the wavelength-converting elements and a part containing no wavelength-converting element are arranged in the longitudinal direction of the core 24.

The light-transmitting material may be, for example, a fluoride, an oxide, or a nitride. The fluoride may be glass fluoride, for example. The oxide may be a silicon oxide or quartz, for example.

The wavelength-converting elements may be a rare earth element. In this embodiment, the wavelength-converting elements include one or more chemical elements selected from the group consisting of, for example, Pr, Tb, Ho, Dy, Er, Eu, Nd and Mn. The wavelength-converting elements are contained as ions of a rare earth element in the core 24, and more specifically contained as, for example, ions of Pr (Pr³⁺) and ions of Tb (Tb³⁺). A wavelength-converting element may be excited by the excitation light P1, or by light (i.e., amplified spontaneous emission (ASE) of light) obtained by amplifying, as inertial seed light, spontaneous emission of light emitted from a different wavelength-converting element other than the wavelength-converting element itself. Through such excitation, the wavelength-converting elements emit the ASE unique to the chemical element(s) of the wavelength-converting elements, and further produce stimulated emission of light having the same wavelength as that of the external seed light P2, and accordingly emit those lights together, as the stimulated emission of light P3. The wavelength of each of the ASE and the external seed light P2 is longer than the wavelength (e.g., which may fall within the range from 400 nm to 450 nm) of the excitation light P1. The wavelength of the seed light P2 will be descried later in the column of "(2.4.3) Second Light Source Part."

The ions of Pr³⁺ are wavelength-converting elements that are able to emit the ASE or the amplified light of the seed light in a range from cyan to red color. The intensity of stimulated emission of light depends on the respective intensities of the inertial seed light (spontaneous emission of light) and the external seed light. If the core 24 contains the ions of Pr³⁺ and the ions of Tb³⁺, the ions of Tb³⁺ are excited by absorbing the ASE emitted from the ions of Pr³⁺, and accordingly may produce the ASE having a wavelength unique to the ions of Tb³⁺.

The clad 25 has a smaller refractive index than that of the core 24. The clad 25 has no wavelength-converting elements, unlike the core 24.

The material of the coating portion 26 may be a resin, for example.

The optical fiber 2 includes the light incident portion 21, the light emerging portion 22 and a wavelength-converting portion 23. The optical fiber 2 has a first end part 210 including the light incident portion 21 and a second end part 220 including the light emerging portion 22.

The light incident portion 21 is a portion on which the excitation light P1 is incident, and includes, for example, the first end face of the core 24. The light emerging portion 22 includes the second end face of the core 24 emerging light, which includes the excitation light P1 and the stimulated emission of light P3 including the ASE.

The light incident portion 21 may include a reflection reducing portion configured to reduce reflection of the excitation light P1 coming from the outside of the optical fiber 2 and being incident on the light incident portion 21. The reflection reducing portion may be implemented as, for example, an anti-reflection coating disposed to cover the first end face of the core 24.

The wavelength-converting portion 23 is disposed between the light incident portion 21 and the light emerging portion 22. The wavelength-converting portion 23 includes wavelength-converting elements. The wavelength-converting elements are excited by the excitation light P1 to emit light having a longer wavelength than the excitation light P1. The wavelength-converting elements include a chemical element(s) that absorbs the excitation light P1 and enables amplifying, through stimulated emission, spontaneous emission of light or seed light, which has a longer wavelength than the excitation light P1.

The core 24 has a diameter falling within a range of 25 µm to 500 µm, for example. The optical fiber 2 has a length falling within a range of 3 m to 10 m, for example. The wavelength-converting portion 23 is preferably set to have a length longer as the concentration of the wavelength-converting elements in the wavelength-converting portion 23 is lower. The numerical aperture of the optical fiber 2 is set to 0.22, for example. The concentration of the wavelength-converting elements in the wavelength-converting portion 23 corresponds to that in the core 24.

### (2.4.2) First Light Source Part

The first light source part 11 emits the excitation light P1 for exciting the wavelength-converting elements included in the wavelength-converting portion 23 of the optical fiber 2. The excitation light P1 emitted from the first light source part 11 is caused to be incident on the light incident portion 21 of the optical fiber 2. In consideration of more efficiently exciting the wavelength-converting elements, the excitation light P1 preferably has a wavelength equal to or longer than 350 nm and equal to or shorter than 500 nm.

The first light source part 11 includes a laser light source, for example. The laser light source emits a laser beam. The excitation light P1 emitted from the first light source part 11 portion 21. The laser light source is assumed to be, for example, a semiconductor laser emitting a blue laser beam. In this case, the excitation light P1 has the wavelength falling within a range of 440 nm to 450 nm, for example. In this case, the excitation light P1 is partially propagated in the optical fiber 2 without exciting the wavelength-converting elements to be emitted as blue light from the light emerging portion 22.

### (2.4.3) Second Light Source Part

The second light source part 12 emits the seed light P2. The seed light P2 emitted from the second light source part 12 is caused to be incident on the light incident portion 21 of the optical fiber 2.

The light source unit 1 includes a plurality of the second light source parts 12 (e.g., two second light source parts 12). Each of the two second light source parts 12 emits the seed light P2 having one wavelength, but the wavelengths thereof are different from each other. Hereinafter, one of the two second light source parts 12 will be referred to also as a second light source part 121 and the remaining one will be referred to also as a second light source part 122 for convenience of explanation. The second light source part 121 is assumed to be, for example, a semiconductor laser emitting green light. The second light source part 122 is assumed to be, for example, a semiconductor laser emitting red light. When the wavelength-converting elements of the wavelength-converting portion 23 include Pr³⁺, the wavelength of the green seed light ray P21 is preferably, for example, about 520 nm and the wavelength of the red seed light ray P22 is preferably, for example, about 640 nm. Each second light source part 12 is a light source emitting quasi-monochromatic light. As used herein, the "quasi-monochromatic light" refers to light falling within a narrow wavelength range (with a width of 10 nm, for example). The number of the second light source parts 12 in the light source unit 1 does not have to be two but may also be three or more, or even one. If the light source unit 1 includes three second light source parts 12, the three second light source parts 12 may include a semiconductor laser emitting green light, a semiconductor laser emitting red light and a semiconductor laser emitting orange light. The wavelength of the orange seed light is preferably about 600 nm, for example.

Light emitted from the second light source part 121 is, as the seed light ray P2(P21), caused to be incident on the light incident portion 21 of the optical fiber 2. Light emitted from the second light source part 122 is, as the seed light ray P2(P22), caused to be incident on the light incident portion 21 of the optical fiber 2.

### (2.4.4) Operation of Light Source Unit

The light source unit 1 causes the first light source part 11 to emit the excitation light P1 and the second light source part 12 to emit the seed light P2. Thus, the light source unit 1 makes the excitation light P1 and the seed light P2 incident on the light incident portion 21 of the optical fiber 2. The excitation light P1 made incident on the light incident portion 21 of the optical fiber 2 is partially emerged from the light emerging portion 22 of the optical fiber 2. In the light source unit 1, light emerged from the light emerging portion 22 of the optical fiber 2 is mixed color light including: the excitation light P1; the ASE having a wavelength of about 480 nm, produced from the wavelength-converting elements; and the stimulated emission of light (P3) having the same wavelength as that of the seed light P2. The two types of stimulated emission of lights P31, P32 are, for example, green light and red light, which correspond to the seed light rays P21, P22 one-to-one and have wavelengths different from each other, respectively. In this case, the mixed color light is, for example, white light. In FIG. 3C, the lower stimulated emission of light P3(P31) is green light, and the upper stimulated emission of light P3(P32) is red light.

In the optical fiber 2, the stimulated emission is produced by the spontaneous emission of light and the seed light P2, and therefore, the excitation light P1 made incident on the light incident portion 21 and the stimulated emission of light P3 amplified by the stimulated emission emerge from the light emerging portion 22. The intensity of the stimulated emission of light P3 having the same wavelength as that of the seed light ray P21, of light emerging from the light emerging portion 22 of the optical fiber 2, is larger than the intensity of the seed light ray P21 emitted from the second light source part 121 and made incident on the light incident portion 21. Also, the intensity of the stimulated emission of light P3 having the same wavelength as that of the seed light ray P22, of light emerging from the light emerging portion 22 of the optical fiber 2, is larger than the intensity of the seed light ray P22 emitted from the second light source part 122 and made incident on the light incident portion 21. The mixed color light emerging from the light emerging portion 22 of the optical fiber 2 is incoherent light. In the light source unit 1, the stimulated emission of light P3 is increased or decreased, as it comes closer to the light emerging portion 22 from the light incident portion 21, of the optical fiber 2. In the light source unit 1, chromaticity, color temperature, color rendering and the like of light emerging from the light emerging portion 22 are decided, depending on the wavelength of the ASE and the wavelength of the seed light P2. Note that the operation of the light source unit 1 is different from the operation of a fiber laser that produces laser oscillation.

In the light source unit 1, the wavelength-converting elements, which will become a heat source, are distributed in the core 24 of the optical fiber 2, which can suppress an increase in temperature while it is being used.

### (2.5) Other Components

In the projection system 100, the light source unit 1 further includes a unit casing 15 configured to house the first light source part 11 and the second light source part 12.

The light source unit 1 may further include an optical coupler 16 for making the excitation light P1 and each seed light P2 incident on the light incident portion 21 of the optical fiber 2. The optical coupler 16 is disposed in an opening part 151 of the unit casing 15. The optical coupler 16 is assumed to be a waveguide type of coupler, but this is only an example and should not be construed as limiting. The optical coupler 16 may be, for example, an optical fiber type of coupler, or the other multi-wavelength combiner. Material for an optical path such as a waveguide type of coupler, an optical fiber type of coupler, or a multi-wavelength combiner is assumed to be e.g., quartz, but this is only an example and should not be construed as limiting. The light source unit 1 may be configured such that the optical coupler 16 includes a lens, and the seed light P2 may be also introduced to the lens of the optical coupler 16 for introducing the excitation light P1. In a structure where the first light source part 11 and the second light source part 12 respectively emit the excitation light P1 and the seed light P2, using optical fibers, the optical fibers may be disposed such that emission lights therefrom are introduced to the optical coupler 16. Furthermore, the light source unit 1 may be configured to adjust incident light (the excitation light P1 and each seed light P2) to the light incident portion 21 of the optical fiber 2, using at least one of a lens, a mirror, a prism, an optical member having a slit allowing light to pass therethrough and the other optical member. The adjustment using at least one of those optical members can be appropriately combined with a case where the first light source part 11 or the second light source part 12 emits light through an optical fiber. An introduction part for the excitation light P1 or the seed light P2, of the optical coupler 16, may include a reflection reducing portion. The reflection reducing portion may be implemented as, for example, an anti-reflection coating.

The light source unit 1 further includes a ventilator 17. The ventilator 17 is disposed in the unit casing 15. Since the light source unit 1 includes the ventilator 17, air in the unit casing 15 can be cooled, which can suppress an increase in temperature of each of the first light source part 11 and the second light source part 12.

The projection system 100 further includes a housing 6 that has four side walls, when viewed from a direction orthogonal to the first directions D1 and the second directions D2. The four side walls include a first side wall 61 and a second side wall 62, which cross the first directions D1, and a third side wall 63 and a fourth side wall 64, which cross the second directions D2. The housing 6 is provided in the first side wall 61 facing the projection optical system 4 with an opening part 611 for emitting light coming from the projection optical system 4. The housing 6 is provided in the third side wall 63 facing the ventilator 17 with a plurality of air vents 631.

The housing 6 of the projection system 100 is also provided in the second side wall 62 facing at least part of the optical fiber 2 with a plurality of air vents 621. Accordingly, the projection system 100 according to the first embodiment can easily release heat generated at the wavelength-converting portion 23 of the optical fiber 2. In the projection system 100 according to the first embodiment, the air vents 621 of the second side wall 62 constitute a cooling unit configured to cool at least the wavelength-converting portion 23. The cooling unit is limited to the air vents 621, but may be, for example, a ventilator disposed in the housing 6. Alternatively, in the projection system 100, the housing 6 may serve also as the cooling unit by the optical fiber 2 being disposed to be in contact with the housing 6. In this case, material for at least part in contact with the optical fiber 2, of the housing 6, preferably includes metal.

The projection system 100 further includes a holder 7 configured to hold the optical fiber 2 in the housing 6. For example, the holder 7 includes a plurality of pairs (four pairs in FIG. 1), each of which is constituted by two protrusions 71 disposed on both sides of the optical fiber 2 in one radial direction of the optical fiber 2 and protruding from a bottom wall 60 of the housing 6. The shortest distance between two protrusions 71 of each pair is larger than a diameter of the optical fiber 2. Each protrusion 71 has an oval shape, when viewed from any one of third directions orthogonal to the first directions D1 and the second directions D2, but this is only an example and should not be construed as limiting. In consideration of stably holding the optical fiber 2 by the holder 7, the protruding dimension of each protrusion 71 is preferably larger than or equal to a radius of the optical fiber 2, more preferably larger than or equal to the diameter of the optical fiber 2. Each protrusion 71 is formed integrally with the housing 6, but this is only an example and should not be construed as limiting. Each protrusion 71 may be formed as another member separately from the housing 6 and fixed to the housing 6. In consideration of efficiently releasing heat of the optical fiber 2, material for each protrusion 71 preferably has a higher thermal conductivity than that of the optical fiber 2.

In the projection system 100 according to the first embodiment, the optical fiber 2 is held in a bent state in the housing 6 by the holder 7.

The light source unit 1 further includes a collimator lens 19 collimating light (white light) emerging from the light emerging portion 22 of the optical fiber 2. Accordingly, light emitted from the light source unit 1 is collimate light.

The projection system 100 according to the first embodiment further includes an optical axis adjustment member 18. The second end part 220 of the optical fiber 2 is fixed to the optical axis adjustment member 18. The optical axis adjustment member 18 is fixed to an optical base disposed in the housing 6. The optical base is a member holding the collimator lens 19, the spatial light modulation unit 3, and the projection optical system 4. The optical axis adjustment member 18 is, for example, a member having a V-shaped groove to which the second end part 220 of the optical fiber 2 is fixed, but this is only an example and should not be construed as limiting. The optical axis adjustment member 18 may be an optical connector to which the second end part 220 of the optical fiber 2 is fixed. The optical base is formed as another member separately from the housing 6 and fixed to the housing 6, but this is only an example and should not be construed as limiting. The optical base may be formed integrally with the housing 6.

The projection system 100 includes: a first drive circuit driving the first light source part 11; a plurality of second drive circuits respectively corresponding to the plurality of second light source parts 12 one-to-one, each second drive circuit driving a corresponding second light source part 12; and a control circuit 10 controlling the first drive circuit and the plurality of second drive circuits individually. The projection system 100 can adjust output of light to be emitted from (the light emerging portion 22 of) the optical fiber 2 by the control circuit 10 controlling the first drive circuit and the plurality of second drive circuits individually. The power supply unit includes, for example, a first power supply circuit configured to supply a power supply voltage to the first drive circuit and the plurality of second drive circuits. The power supply unit further includes, for example, a second power supply circuit configured to supply a power supply voltage to the control circuit. The first power supply circuit and the second power supply circuit are not included in the components of the projection system 100, but this is only an example and should not be construed as limiting. The first power supply circuit and the second power supply circuit may be included in the components of the projection system 100.

### (3) Recapitulation

The projection system 100 according to the first embodiment includes a light source unit 1, a spatial light modulation unit 3, and a projection optical system 4. The spatial light modulation unit 3 is configured to control emission light emitted from the light source unit 1 to form an optical image. The projection optical system 4 is configured to project the optical image formed by the spatial light modulation unit 3. The light source unit 1 includes an optical fiber 2, a first light source part 11, and a second light source part 12. The optical fiber 2 includes a light incident portion 21, a light emerging portion 22 and a wavelength-converting portion 23. The wavelength-converting portion 23 is disposed between the light incident portion 21 and the light emerging portion 22. The wavelength-converting portion 23 includes wavelength-converting elements. The wavelength-converting elements are able to be excited by excitation light P1 to produce spontaneous emission of light having a longer wavelength than the excitation light P1, and also excited by amplified spontaneous emission of light. The first light source part 11 is configured to make the excitation light P1 incident on the light incident portion 21. The second light source part 12 is configured to make seed light P2 incident on the light incident portion 21. The seed light P2 causes the wavelength-converting elements excited by the excitation light P1 or the amplified spontaneous emission of light to produce stimulated emission of light P3.

The projection system 100 according to the first embodiment can suppress an increase in temperature.

In the projection system 100 according to the first embodiment, the wavelength-converting portion 23 includes, as wavelength-converting elements, Pr³⁺, and the projection system 100 not only emits the cyan color ASE, but also makes the seed light P2 having the plurality of wavelengths incident on the light incident portion 21, which can enhance the intensities of the green stimulated emission of light and the red stimulated emission of light. Accordingly, the projection system 100 according to the first embodiment can improve color rendering of light (white light) emitted from the light source unit 1, and further improve color rendering of white light emitted from the spatial light modulation unit 3. Furthermore, in the projection system 100 according to the first embodiment, the wavelength-converting portion 23 includes, as two types of wavelength-converting elements, Pr³⁺ and Tb³⁺, which can further improve the color rendering of the light emitted from the light source unit 1.

### (Second Embodiment)

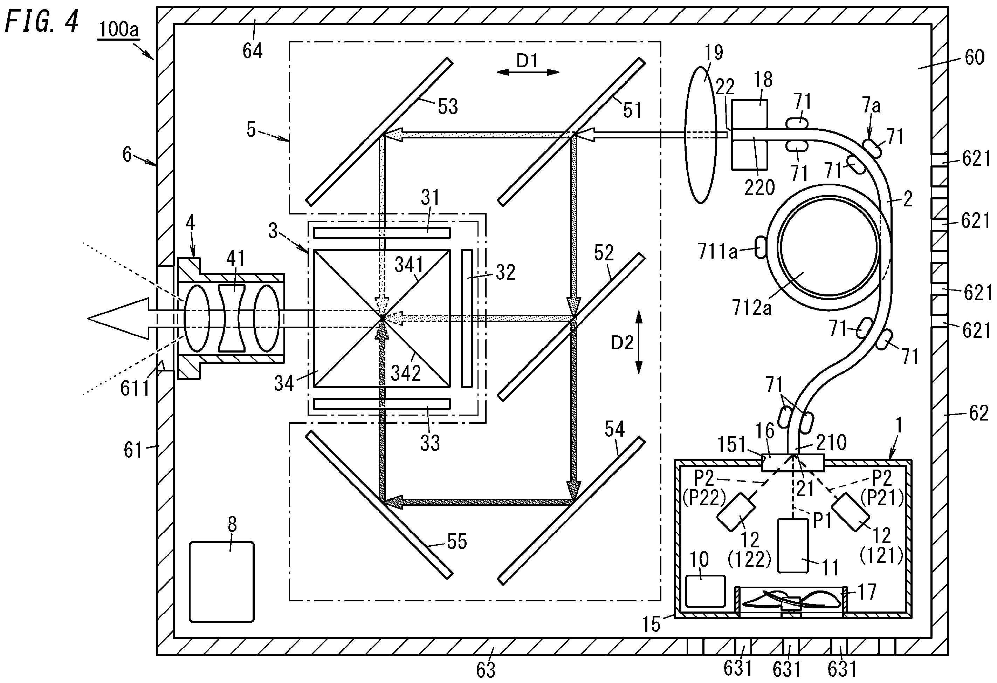

Hereinafter, a projection system 100a according to the second embodiment will be described with reference to FIG. 4.

The projection system 100a according to the second embodiment is different from the projection system 100 according to the first embodiment in that a holder 7a is provided instead of the holder 7 in the projection system 100 according to the first embodiment. Hereinafter, components of the projection system 100a according to the second embodiment, which are the same as those of the projection system 100 according to the first embodiment, are assigned with the same reference signs, and explanations thereof will be omitted as appropriate.

The holder 7a includes a pair of a protrusion 711a and a protrusion 712a having shapes different from each other, instead of one of a plurality of pairs, each of which is constituted by two protrusions 71. The protrusion 711a has an oval shape, when viewed from any one of third directions orthogonal to first directions D1 and second directions D2. The protrusion 712a is larger than the protrusion 711a, when viewed from any one of the third directions. The shortest distance between the protrusion 711a and the protrusion 712a is larger than a diameter of an optical fiber 2. The protrusion 712a has a circle shape with a larger radius than an allowable bend radius of the optical fiber 2, when viewed from any one of the third directions. In the projection system 100a according to the second embodiment, the optical fiber 2 is partially wrapped around the protrusion 712a to be held by the protrusion 711a and the protrusion 712a. The protruding dimension of each of the protrusion 711a and the protrusion 712a is preferably larger than or equal to the diameter of the optical fiber 2. In the projection system 100a, the number of turns of the optical fiber 2 with respect to the protrusion 712a can be increased depending on an increase in the protruding dimension of each of the protrusion 711a and the protrusion 712a, which can accordingly increase the length of the optical fiber 2 in the housing 6 without an increase in the size of the housing 6, when viewed from any one of the third directions.

Since the optical fiber 2 is held with being partially wrapped around the protrusion 712a, the projection system 100a according to the second embodiment can achieve higher optical output by increasing the length of the optical fiber 2, compared with the projection system 100 according to the first embodiment. Also, since the optical fiber 2 is held with being partially wrapped around the protrusion 712a, the projection system 100a according to the second embodiment can be further downsized (for example, when the optical fiber 2 is set to have the same length as that of the optical fiber 2 of the projection system 100 according to the first embodiment), compared with the projection system 100 according to the first embodiment.

### (Third Embodiment)

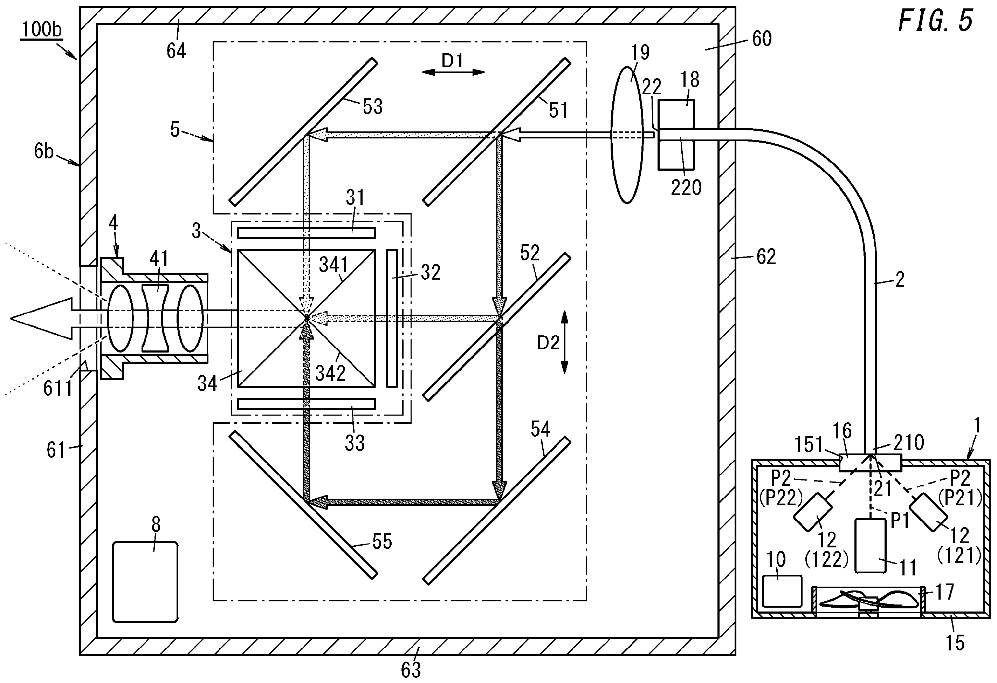

Hereinafter, a projection system 100b according to the third embodiment will be described with reference to FIG. 5.

The projection system 100b according to the third embodiment is different from the projection system 100 according to the first embodiment in that a housing 6b is provided instead of the housing 6 in the projection system 100 according to the first embodiment and further part of an optical fiber 2 and a unit casing 15 are disposed outside of the housing 6b. Hereinafter, components of the projection system 100b according to the third embodiment, which are the same as those of the projection system 100 according to the first embodiment, are assigned with the same reference signs, and explanations thereof will be omitted as appropriate.

In the projection system 100b according to the third embodiment, the housing 6b can be further downsized and the heat dissipation can be further improved, compared with the housing 6 of the projection system 100 according to the first embodiment.

In the projection system 100b according to the third embodiment, the length of the optical fiber 2 can be easily increased, which can reduce the concentration of the wavelength-converting elements. The heat dissipation can be therefore improved.

Also in the projection system 100b according to the third embodiment, the length of the optical fiber 2 can be easily increased, which can achieve higher optical output of the light source unit 1.

Furthermore, the projection system 100b according to the third embodiment can enhance a flexibility in the length of the optical fiber 2 and a flexibility in routing of the optical fiber 2, which can enhance a flexibility in the installation location of the projection system 100b.

### (Fourth Embodiment)

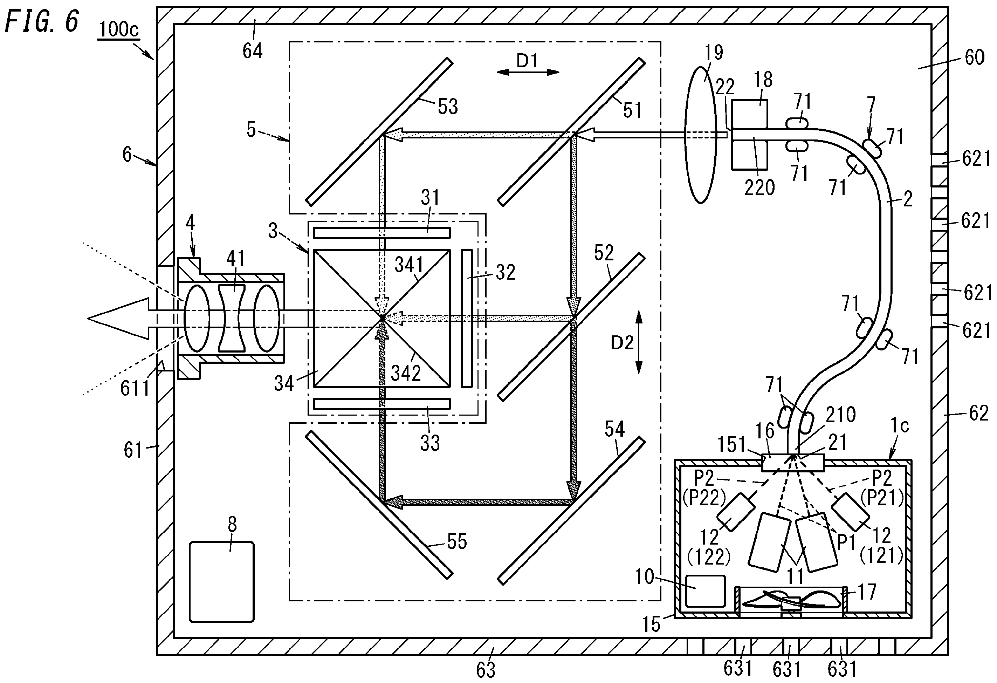

Hereinafter, a projection system 100c according to the fourth embodiment will be described with reference to FIG. 6.

The projection system 100c according to the fourth embodiment is different from the projection system 100 according to the first embodiment in that a light source unit 1c is provided instead of the light source unit 1 according to the first embodiment. Hereinafter, components of the projection system 100c according to the fourth embodiment, which are the same as those of the projection system 100 according to the first embodiment, are assigned with the same reference signs, and explanations thereof will be omitted as appropriate.

The light source unit 1c includes a plurality of first light source parts 11 (two in the example of the drawing) corresponding to one optical fiber 2.

The projection system 100c according to the fourth embodiment can achieve higher optical output of the light source unit 1c, even in case of, for example, insufficient optical output of each first light source part 11.

### (Fifth Embodiment)

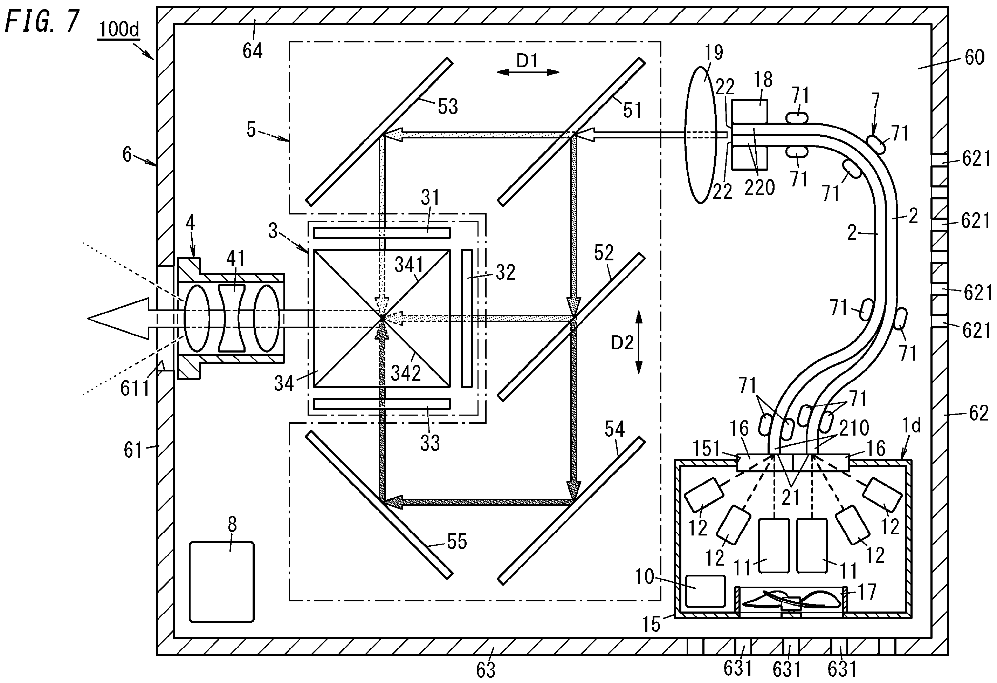

Hereinafter, a projection system 100d according to the fifth embodiment will be described with reference to FIG. 7.

The projection system 100d according to the fifth embodiment is different from the projection system 100 according to the first embodiment in that a plurality of optical fibers 2 (two in the example of the drawing) are provided. Furthermore, the projection system 100d according to the fifth embodiment is different from the projection system 100 according to the first embodiment in that a light source unit 1d is provided instead of the light source unit 1 of the projection system 100 according to the first embodiment. Hereinafter, components of the projection system 100d according to the fifth embodiment, which are the same as those of the projection system 100 according to the first embodiment, are assigned with the same reference signs, and explanations thereof will be omitted as appropriate.

In the projection system 100d according to the fifth embodiment, the light source unit 1d includes a first light source part 11 and a plurality of (two) second light source parts 12 for each of the plurality of (two) optical fibers 2. In other words, the light source unit 1d includes two sets, each of which is constituted by one first light source part 11 and two second light source parts 12. Those two sets are housed in one unit casing 15. A control circuit 10 is configured to control the first light source part 11 and the plurality of second light source parts 12 of each set.

The holder 7 holds, with each of two pairs of protrusions 71, a corresponding one of the two optical fibers 2 in the vicinity of the first end parts 210 thereof and further holds, with each of some pairs of protrusions 71, the two optical fibers 2 together in the vicinity of the second end parts 220 thereof. The shortest distance between the two protrusions 71 of the pair, holding the corresponding one of the two optical fibers 2, is larger than a diameter of the corresponding one. Also, the shortest distance between the two protrusions 71 of each of some pairs, holding the two optical fibers 2 together, is larger than the total of diameters of the two optical fibers 2.

The projection system 100d according to the fifth embodiment can achieve higher optical output of the light source unit 1d, even in case that, for example, the length of each optical fiber 2 is restricted to downsize the projection system 100d.

### (Sixth Embodiment)

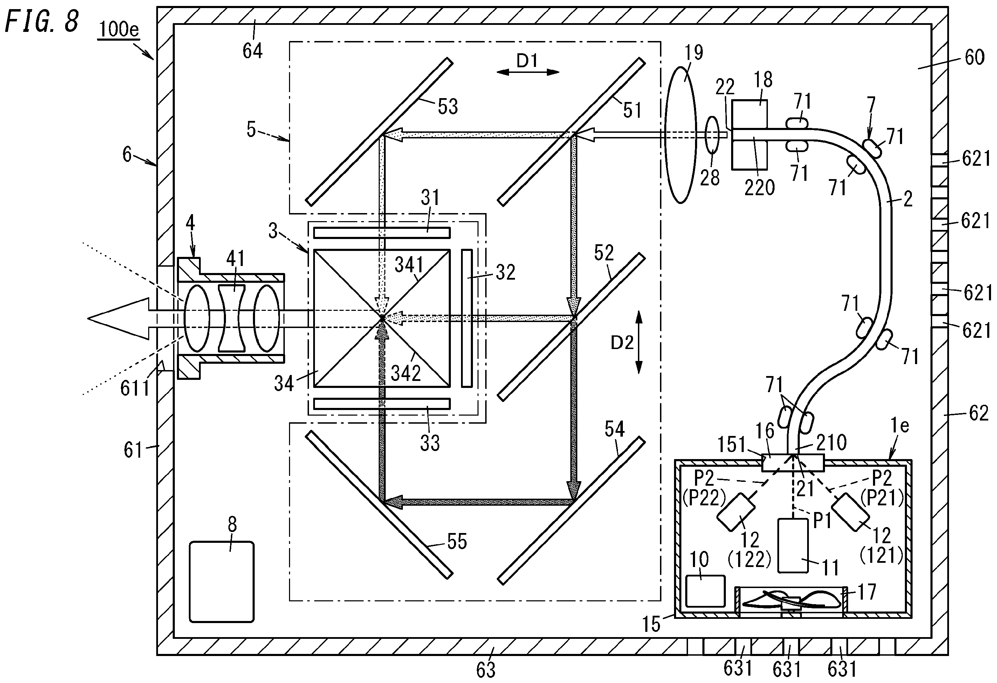

Hereinafter, a projection system 100e according to the sixth embodiment will be described with reference to FIG. 8.

The projection system 100e according to the sixth embodiment is different from the projection system 100 according to the first embodiment in that a light source unit 1e is provided instead of the light source unit 1 of the projection system 100 according to the first embodiment. Hereinafter, components of the projection system 100e according to the sixth embodiment, which are the same as those of the projection system 100 according to the first embodiment, are assigned with the same reference signs, and explanations thereof will be omitted as appropriate.

The light source unit 1e further includes a lens 28 condensing light emerging from a light emerging portion 22 of an optical fiber 2. The lens 28 is disposed between the light emerging portion 22 of the optical fiber 2 and a collimator lens 19.

The projection system 100e according to the sixth embodiment can more effectively use the light emitted from the light emerging portion 22 of the optical fiber 2, which can achieve higher optical output. Therefore, the projection system 100e can achieve lower power consumption.

### (Other Variations)

The foregoing first to sixth embodiments are mere ones of various embodiments of the present disclosure. Various modifications may be made to the foregoing first to sixth embodiments depending on design and the like as long as the object of the present disclosure is achieved.

For example, the number of wavelength-converting portions 23 between the light incident portion 21 and the light emerging portion 22 in the optical fiber 2 does not have to be one but may also be multiple, for example. In this case, the plurality of wavelength-converting portions 23 may be arranged side by side along the optical axis direction of the core 24.

In the optical fiber 2 described above, the wavelength-converting portion 23 is approximately as long as the core 24. However, this is only an example and should not be construed as limiting. Alternatively, the wavelength-converting portion 23 may also be shorter than the core 24.

The laser light source in the first light source part 11 does not have to be the semiconductor laser emitting a blue laser beam, but may also be a semiconductor laser emitting, for example, a violet laser beam. Also, the first light source part 11 does not have to include the semiconductor laser but may have a configuration including, for example, a light emitting diode (LED) light source and an optical system.

The second light source part 121 does not have to be the semiconductor laser emitting green light, but may also be, for example, an LED emitting green light. Also, the second light source part 122 does not have to be the semiconductor laser emitting red light, but may also be, for example, an LED emitting red light.

In the projection system 100 according to the first embodiment, the relative positional relationship between: a group consisting of the first light source part 11 and the plurality of second light source parts 12; and the light incident portion 21 of the optical fiber 2 is not limited in particular. For example, in the projection system 100, the relative positional relationship may be changed by disposing a cross dichroic prism between the group consisting of the first light source part 11 and the plurality of second light source parts 12 and the light incident portion 21 of the optical fiber 2.

The holder 7 does not have to include a plurality of pairs, each of which is constituted by two protrusions 71, as long as the holder 7 holds the optical fiber 2 without the optical fiber 2 being bent at a smaller bend radius than the allowable bend radius (referred to also as a minimum bending radius). For example, the holder 7 may include at least one of a groove formed in the bottom wall 60 of the housing 6 and a groove formed in the second side wall 62. Alternatively, the holder 7 may be, as another member separately from the housing 6, a clip disposed in the housing 6 and holding the optical fiber 2 between the clip and the housing 6.

In the projection system 100d according to the fifth embodiment, the first light source part 11 and the plurality of second light source parts 12 are provided so as to correspond to each of the plurality of optical fibers 2, but this is only an example and should not be construed as limiting. For example, the projection system 100d may include a first beam splitter and a plurality of second beam splitters with respect to a set of the first light source part 11 and the plurality of second light source parts 12. The first beam splitter may be provided to cause the excitation light P1 emitted from the first light source part 11 to enter the plurality of optical fibers 2. The plurality of second beam splitters may be provided to cause the seed light P2 emitted from each of the plurality of second light source parts 12 to enter the plurality of optical fibers 2.

### Reference Signs List

- 1, 1c, 1d, 1e: Light Source Unit
- 2: Optical Fiber
- 21: Light Incident Portion
- 22: Light Emerging Portion
- 23: Wavelength-Converting Portion
- 28: Lens
- 3: Spatial Light Modulation Unit
- 4: Projection Optical System
- 6, 6b: Housing
- 7, 7a: Holder
- 11: First Light Source Part
- 12: Second Light Source Part
- 121: Second Light Source Part
- 122: Second Light Source Part
- 15: Unit Casing
- 16: Optical Coupler
- 17: Ventilator
- 18: Optical Axis Adjustment Member
- 19: Collimator Lens
- 100, 100a, 100b, 100c, 100d, 100e: Projection System
- P1: Excitation Light
- P2: Seed Light
- P21: Seed Light Ray
- P22: Seed Light Ray
- P3: Stimulated Emission of Light
- P31: Stimulated Emission of Light
- P32: Stimulated Emission of Light

## Claims

1. A projection system (100, 100a, 100b, 100c, 100d, 100e), comprising:
a light source unit (1, 1c, 1d, 1e);
a spatial light modulation unit (3) configured to control emission light emitted from the light source unit (1, 1c, 1d, 1e) to form an optical image; and
a projection optical system (4) configured to project the optical image formed by the spatial light modulation unit (3),
the light source unit (1, 1c, 1d, 1e) including:
an optical fiber (2) including a light incident portion (21), a light emerging portion (22) and a wavelength-converting portion (23), the wavelength-converting portion (23) being disposed between the light incident portion (21) and the light emerging portion (22), and the wavelength-converting portion (23) including wavelength-converting elements that are able to be excited by excitation light (P1) to produce spontaneous emission of light having a longer wavelength than the excitation light (P1), and also excited by amplified spontaneous emission of light;
a first light source part (11) configured to make the excitation light (P1) incident on the light incident portion (21); and
a plurality of second light source parts (12, 121, 122) respectively configured to make seed lights (P2) incident on the light incident portion (21), the seed lights (P2) causing respectively the wavelength-converting elements excited by the excitation light (P1) or the amplified spontaneous emission of light to produce stimulated emission of light (P3, P31, P32), the plurality of second light source parts (12, 121, 122) being respectively configured to output a plurality of seed lights (P2) having wavelengths different from each other,
wherein
the light source unit (1, 1c, 1d, 1e) further includes a lens (28) condensing light emerging from the light emerging portion (22),
a mixed color light emerging from the light emerging portion (22) of the optical fiber (2) is incoherent light.

2. The projection system (100, 100a, 100b, 100c, 100d, 100e) of claim 1, wherein
the first light source part (11) includes a laser light source.

3. The projection system (100, 100a, 100b, 100c, 100d, 100e) of claim 1 or 2, wherein
the light source unit (1, 1c, 1d, 1e) includes multiple sets, each of which includes at least one of multiple optical fibers (2), at least one of multiple first light source parts (11), and two or more of multiple second light source parts (12) (12, 121, 122), and
the optical fiber (2) is one of the plurality of optical fibers (2), the first light source part (11) is one of the plurality of first light source parts (11), and the plurality of second light source parts (12, 121, 122) are two or more of the multiple second light source parts (12, 121, 122).

4. The projection system (100, 100a, 100b, 100c, 100d, 100e) of any one of claims 1 to 3, wherein
the light source unit (1, 1c, 1d, 1e) includes a plurality of first light source parts (11) corresponding to the optical fiber (2), and the first light source part (11) is one of the plurality of first light source parts (11).

5. The projection system (100, 100a, 100b, 100c, 100d, 100e) of any one of claims 1 to 4, further comprising a housing (6, 6b) configured to house at least the optical fiber (2), the spatial light modulation unit (3) and the projection optical system (4).

6. The projection system (100, 100a, 100b, 100c, 100d, 100e) of claim 5, further comprising a holder (7, 7a) configured to hold the optical fiber (2) in the housing (6, 6b).

7. The projection system (100, 100a, 100b, 100c, 100d, 100e) of claim 6, wherein
the optical fiber (2) is held in a bent state in the housing (6, 6b) by the holder (7, 7a).

8. The projection system (100, 100a, 100b, 100c, 100d, 100e) of any one of claims 1 to 7, further comprising a cooling unit configured to cool at least the wavelength-converting portion (23).

9. The projection system (100, 100a, 100b, 100c, 100d, 100e) of any one of claims 1 to 8, wherein
each of the second light source parts (12, 121, 122) includes a laser light source.

10. The projection system (100, 100a, 100b, 100c, 100d, 100e) of any one of claims 1 to 9, wherein
the wavelength-converting elements include one or more chemical elements selected from the group consisting of Pr, Tb, Ho, Dy, Er, Eu, Nd and Mn.

## Patentansprüche

1. Projektionssystem (100, 100a, 100b, 100c, 100d, 100e), umfassend:
eine Lichtquelleneinheit (1, 1c, 1d, 1e);
eine räumliche Lichtmodulationseinheit (3), die konfiguriert ist, Emissionslicht zu steuern bzw. zu regeln, das von der Lichtquelleneinheit (1, 1c, 1d, 1e) emittiert wird, um ein optisches Bild zu erzeugen; und
ein optisches Projektionssystem (4), das konfiguriert ist, das von der räumlichen Lichtmodulationseinheit (3) erzeugte optische Bild zu projizieren,
wobei die Lichtquelleneinheit (1, 1c, 1d, 1e) beinhaltet:
einen Lichtwellenleiter (2), der einen Lichteinfallsabschnitt (21), einen Lichtaustrittsabschnitt (22) und einen Wellenlängenumwandlungsabschnitt (23) beinhaltet, wobei der Wellenlängenumwandlungsabschnitt (23) zwischen dem Lichteinfallsabschnitt (21) und dem Lichtaustrittsabschnitt (22) angeordnet ist und der Wellenlängenumwandlungsabschnitt (23) Wellenlängenumwandlungselemente beinhaltet, die durch Anregungslicht (P1) angeregt werden können, um eine spontane Emission von Licht mit einer längeren Wellenlänge als das Anregungslicht (P1) zu erzeugen, und die auch durch verstärkte spontane Lichtemission angeregt werden können; einen ersten Lichtquellenteil (11), der konfiguriert ist, das Anregungslicht (P1) auf den Lichteinfallsabschnitt (21) einfallen zu lassen; und
eine Mehrzahl von zweiten Lichtquellenteilen (12, 121, 122), die jeweils konfiguriert sind, Seed-Lichter (P2) auf den Lichteinfallsabschnitt (21) einfallen zu lassen, wobei die Seed-Lichter (P2) die durch das Anregungslicht (P1) oder die verstärkte spontane Lichtemission angeregten Wellenlängenumwandlungselemente jeweils veranlassen, eine stimulierte Lichtemission (P3, P31, P32) zu erzeugen, wobei die Mehrzahl von zweiten Lichtquellenteilen (12, 121, 122) jeweils konfiguriert ist, eine Mehrzahl von Seed-Lichtern (P2) mit voneinander unterschiedlichen Wellenlängen auszugeben,
wobei
die Lichtquelleneinheit (1, 1c, 1d, 1e) ferner eine Linse (28) beinhaltet, die aus dem Lichtaustrittsabschnitt (22) austretendes Licht bündelt,
ein aus dem Lichtaustrittsabschnitt (22) des Lichtwellenleiters (2) austretendes Mischfarbenlicht inkohärentes Licht ist.

2. Projektionssystem (100, 100a, 100b, 100c, 100d, 100e) nach Anspruch 1, wobei der erste Lichtquellenteil (11) eine Laserlichtquelle beinhaltet.

3. Projektionssystem (100, 100a, 100b, 100c, 100d, 100e) nach Anspruch 1 oder 2, wobei
die Lichtquelleneinheit (1, 1c, 1d, 1e) mehrere Sätze beinhaltet, von denen jeder zumindest einen von mehreren Lichtwellenleitern (2), zumindest einen von mehreren ersten Lichtquellenteilen (11) und zwei oder mehr von mehreren zweiten Lichtquellenteilen (12) (12, 121, 122) beinhaltet, und
der Lichtwellenleiter (2) einer der Mehrzahl von Lichtwellenleitern (2) ist, der erste Lichtquellenteil (11) einer der Mehrzahl von ersten Lichtquellenteilen (11) ist und die Mehrzahl von zweiten Lichtquellenteilen (12, 121, 122) zwei oder mehr der mehreren zweiten Lichtquellenteile (12, 121, 122) sind.

4. Projektionssystem (100, 100a, 100b, 100c, 100d, 100e) nach einem der Ansprüche 1 bis 3, wobei
die Lichtquelleneinheit (1, 1c, 1d, 1e) eine Mehrzahl von ersten Lichtquellenteilen (11) beinhaltet, die dem Lichtwellenleiter (2) entsprechen, und der erste Lichtquellenteil (11) einer der Mehrzahl von ersten Lichtquellenteilen (11) ist.

5. Projektionssystem (100, 100a, 100b, 100c, 100d, 100e) nach einem der Ansprüche 1 bis 4, ferner umfassend ein Gehäuse (6, 6b), das konfiguriert ist, zumindest den Lichtwellenleiter (2), die räumliche Lichtmodulationseinheit (3) und das optische Projektionssystem (4) aufzunehmen.

6. Projektionssystem (100, 100a, 100b, 100c, 100d, 100e) nach Anspruch 5, ferner umfassend einen Halter (7, 7a), der konfiguriert ist, den Lichtwellenleiter (2) in dem Gehäuse (6, 6b) zu halten.

7. Projektionssystem (100, 100a, 100b, 100c, 100d, 100e) nach Anspruch 6, wobei der Lichtwellenleiter (2) durch den Halter (7, 7a) in einem gebogenen Zustand in dem Gehäuse (6, 6b) gehalten ist.

8. Projektionssystem (100, 100a, 100b, 100c, 100d, 100e) nach einem der Ansprüche 1 bis 7, ferner umfassend eine Kühleinheit, die konfiguriert ist, zumindest den Wellenlängenumwandlungsabschnitt (23) zu kühlen.

9. Projektionssystem (100, 100a, 100b, 100c, 100d, 100e) nach einem der Ansprüche 1 bis 8, wobei
jeder der zweiten Lichtquellenteile (12, 121, 122) eine Laserlichtquelle beinhaltet.

10. Projektionssystem (100, 100a, 100b, 100c, 100d, 100e) nach einem der Ansprüche 1 bis 9, wobei
die Wellenlängenumwandlungselemente ein oder mehrere chemische Elemente ausgewählt aus der Gruppe bestehend aus Pr, Tb, Ho, Dy, Er, Eu, Nd und Mn beinhalten.

## Revendications

1. Système de projection (100, 100a, 100b, 100c, 100d, 100e), comprenant :
un module de source lumineuse (1, 1c, 1d, 1e) ;
un module de modulation lumineuse spatiale (3) configuré pour commander de la lumière d'émission émise depuis le module de source lumineuse (1, 1c, 1d, 1e) pour former une image optique ; et
un système optique de projection (4) configuré pour projeter l'image optique formée par le module de modulation lumineuse spatiale (3),
le module de source lumineuse (1, 1c, 1d, 1e) incluant :
une fibre optique (2) incluant une portion incidente lumineuse (21), une portion d'émergence lumineuse (22) et une portion de conversion de longueur d'onde (23), la portion de conversion de longueur d'onde (23) étant disposée ente la portion incidente lumineuse (21) et la portion d'émergence lumineuse (22), et la portion de conversion de longueur d'onde (23) incluant des éléments de conversion de longueur d'onde qui sont capables d'être excités par de la lumière d'excitation (P1) pour produire une émission spontanée de lumière ayant une longueur d'onde plus longue que la lumière d'excitation (P1), et également excités par une émission spontanée amplifiée de lumière ;
une première partie de source lumineuse (11) configurée pour rendre la lumière d'excitation (P1) incidente sur la portion incidente lumineuse (21) ; et
une pluralité de secondes parties de source lumineuse (12, 121, 122) configurées respectivement pour rendre des lumières sources (P2) incidentes sur la portion incidente lumineuse (21), les lumières sources (P2) amenant respectivement les éléments de conversion de longueur d'onde excités par la lumière d'excitation (P1) ou l'émission spontanée amplifiée de lumière à produire une émission stimulée de lumière (P3, P31, P32), la pluralité de secondes parties de source lumineuse (12, 121, 122) étant respectivement configurées pour émettre une pluralité de lumières sources (P2) ayant des longueurs d'onde différentes l'une de l'autre,
dans lequel
le module de source lumineuse (1, 1c, 1d, 1e) inclut en outre une lentille (28) condensant de la lumière émergeant de la portion d'émergence lumineuse (22),
une lumière colorée mélangée émergeant de la portion d'émergence lumineuse (22) de la fibre optique (2) est de la lumière incohérente.

2. Système de projection (100, 100a, 100b, 100c, 100d, 100e) selon la revendication 1, dans lequel
la première partie de source lumineuse (11) inclut une source de lumière laser.

3. Système de projection (100, 100a, 100b, 100c, 100d, 100e) selon la revendication 1 ou 2, dans lequel
le module de source lumineuse (1, 1c, 1d, 1e) inclut de multiples ensembles dont chacun inclut au moins une de multiples fibres optiques (2), au moins une de multiples premières parties de source lumineuse (11) et deux ou plus de multiples secondes parties de source lumineuse (12) (12, 121, 122), et
la fibre optique (2) est une de la pluralité de fibres optiques (2), la première partie de source lumineuse (11) est une de la pluralité de premières parties de source lumineuse (11), et la pluralité de secondes parties de source lumineuse (12, 121, 122) sont deux ou plus des multiples secondes parties de source lumineuse (12, 121, 122).

4. Système de projection (100, 100a, 100b, 100c, 100d, 100e) selon l'une quelconque des revendications 1 à 3, dans lequel
le module de source lumineuse (1, 1c, 1d, 1e) inclut une pluralité de premières parties de source lumineuse (11) correspondant à la fibre optique (2), et la première partie de source lumineuse (11) est une de la pluralité de premières parties de source lumineuse (11).

5. Système de projection (100, 100a, 100b, 100c, 100d, 100e) selon l'une quelconque des revendications 1 à 4, comprenant en outre un logement (6, 6b) configuré pour héberger au moins la fibre optique (2), le module de modulation lumineuse spatiale (3) et le système optique de projection (4).

6. Système de projection (100, 100a, 100b, 100c, 100d, 100e) selon la revendication 5, comprenant en outre un support (7, 7a) configuré pour maintenir la fibre optique (2) dans le logement (6, 6b).

7. Système de projection (100, 100a, 100b, 100c, 100d, 100e) selon la revendication 6, dans lequel
la fibre optique (2) est maintenue dans un état courbé dans le logement (6, 6b) par le support (7, 7a).

8. Système de projection (100, 100a, 100b, 100c, 100d, 100e) selon l'une quelconque des revendications 1 à 7, comprenant en outre un module de refroidissement configuré pour refroidir au moins la portion de conversion de longueur d'onde (23).

9. Système de projection (100, 100a, 100b, 100c, 100d, 100e) selon l'une quelconque des revendications 1 à 8, dans lequel
chacune des secondes parties de source lumineuse (12, 121, 122) inclut une source de lumière laser.

10. Système de projection (100, 100a, 100b, 100c, 100d, 100e) selon l'une quelconque des revendications 1 à 9, dans lequel
les éléments de conversion de longueur d'onde incluent un ou plusieurs éléments chimiques sélectionnés parmi le groupe constitué de Pr, Tb, Ho, Dy, Er, Eu, Nd et Mn.
